# EUROPEAN PATENT SPECIFICATION

(11) **EP 1 312 683 B1**
(45) Date of publication and mention of the grant of the patent: **28.12.2005**
(21) Application number: 02024303.6
(22) Date of filing: 31.10.2002
(51) Int. Cl.: C12Q 1/68, G01N 27/447

(54) **Micro-electrical detector on-chip**
Mikroelektronischer Detektor auf einem Chip
Détecteur micro-électrique sur micropuce

(30) Priority: 08.11.2001 KR 2001069502
(43) Date of publication of application: 21.05.2003
(73) Proprietor: SAMSUNG ELECTRONICS CO., LTD., Suwon-City, Kyungki-do (KR)
(72) Inventor: Yoon, Dae-sung, Seongnam-si, Gyeonggi-do (KR); Cho, Yoon-kyoung, 203-1605 Hwanggol Maeul, Paldal-gu, Suwon-si, Gyeonggi-do (KR); Kang, Seong-ho, Siheung-si, Gyeonggi-do (KR); Lee, Young-sun, Kiheung-eub, Yongin-si, Gyeonggi-do (KR); Lim, Geun-bae, 232-1205 Hwanggol Maeul Poongglim, Paldal-gu, Suwon-si, Gyeonggi-do (KR)
(74) Representative: Grünecker, Kinkeldey, Stockmair & Schwanhäusser Anwaltssozietät

(56) References cited:
- EP-A- 1 016 864
- WO-A-00/42424
- WO-A-01/69226
- DE-A- 4 314 755
- US-A- 5 766 934
- US-A- 5 856 174
- US-A- 5 858 187
- US-A- 5 976 336
- US-A- 6 126 804
- GUIJT ROSANNE M ET AL: "Capillary electrophoresis with on-chip four-electrode capacitively coupled conductivity detection for application in bioanalysis." ELECTROPHORESIS, vol. 22, no. 12, August 2001 (2001-08), pages 2537-2541, XP009008904 ISSN: 0173-0835
- WANG J ET AL: "INTEGRATED ELECTROPHORESIS CHIPS/AMPEROMETRIC DETECTION WITH SPUTTERED GOLD WORKING ELECTRODES" ANALYTICAL CHEMISTRY, AMERICAN CHEMICAL SOCIETY. COLUMBUS, US, vol. 71, no. 17, 1 September 1999 (1999-09-01), pages 3901-3904, XP000854146 ISSN: 0003-2700
- WOOLLEY A T ET AL: "FUNCTIONAL INTEGRATION OF PCR AMPLIFICATION AND CAPILLARY ALECTROPHORESIS IN A MICROFABRICATED DNA ANALYSIS DEVICE" ANALYTICAL CHEMISTRY, AMERICAN CHEMICAL SOCIETY. COLUMBUS, US, vol. 68, no. 23, 1 December 1996 (1996-12-01), pages 4081-4086, XP000642027 ISSN: 0003-2700
- WOOLLEY A T ET AL: "Ultra-high-speed DNA fragment separations using microfabricated capillary array electrophoresis chips" PROCEEDINGS OF THE NATIONAL ACADEMY OF SCIENCES OF USA, NATIONAL ACADEMY OF SCIENCE. WASHINGTON, US, vol. 91, no. 24, November 1994 (1994-11), pages 11348-11352, XP002155992 ISSN: 0027-8424
- BURNS M A ET AL: "MICROFABRICATED STRUCTURES FOR INTEGRATED DNA ANALYSIS" PROCEEDINGS OF THE NATIONAL ACADEMY OF SCIENCES OF USA, NATIONAL ACADEMY OF SCIENCE. WASHINGTON, US, vol. 93, May 1996 (1996-05), pages 5556-5561, XP000953502 ISSN: 0027-8424

## Description

### BACKGROUND OF THE INVENTION

### 1. Field of the Invention

The present invention relates to a micro-electrical detector, and a method for detecting biological material. More specifically, the present invention relates to a micro-electric detector, by which dielectric properties of a test sample can be measured on chip, and a method for detecting a biological material in the test sample.

### 2. Description of the Related Art

Recently, complete decoding of human genome accelerates developments in the area of bio-chip system useful for searching genetic information in a short time, and diagnosing diseases.

Most of commercially available bio-chip systems use a pure gene sample prepared by a series of isolation and amplification processes including separating, purifying, amplifying and electrophoresis using blood or cell.

A Bio-chip, particularly a lab-on-a-chip, is a very interesting tool for biological and chemical analyses, in which PCR (polymerase chain reaction) and CE (capillary electrophoresis) are two important technologies. PCR is a method for the in-vitro amplification of nucleic acid molecules. The PCR technique is rapidly replacing many other time-consuming and less sensitive techniques for the identification of biological species and pathogens in forensic, environmental, clinical and industrial samples. CE chip also features very quick separation and high sensitivity. A PCR/CE chip means an integrated chip for performing polymerase chain reaction (PCR) amplification and capillary electrophoresis (CE) in a single device.

Developments have been made in PCR chip and electrophoresis chip, which include a substrate made of silicone, glass or polymer on which channels and reaction chambers are formed by micro-electro-machining-system (MEMS) technology.

Conventional methods for detecting a desired pure gene separated on PCR chip or electrophoresis chip in micro-analysis system, include optical measurements involving either fluorescence or UV absorption, and electrochemical technique. However, these methods require an expensive equipment, as well as have many problems in making such an integrated chip due to complexity of detecting process.

For example, optical techniques require a variety of optical components such as filter and micro-mirror in addition to microscope and laser source. Accordingly, in these techniques, considerable cost and space are required, thus integrating several components in a small disposable chip is very difficult to achieve. In order to solve this problem, a device has been developed having components, such as laser diode and filter, mounted as a thin film in a chip. However, this method also requires high cost in manufacturing the device, and thus it is not desirable to be applied to a disposable chip.

Also, electrochemical techniques require a complex structure of three or more electrodes and two or more materials for each electrode, and thus manufacturing process of a chip employing the same is complicated. In addition, since this method induces problems in compatibility of PCR product solution as a detecting condition, it is necessary to adjust such a condition to be appropriate for detection.

There are provided electrodes formed in arrayed hybridization chambers, immobilizing probe DNA on the electrodes therein, and then any changes in dielectric constant or dielectric loss are measured, thereby detecting whether target DNA reacts or not. By this method, although it is observed that the immobilized DNA changes from single strand to double strands, moving DNA floating in fluid in a microchannel cannot be detected.

Document DE4314755A1 discloses an electrophoretic separation method and a device for carrying out chemical and biochemical analysis.

Guijt et al. disclose in "Electrophoresis 2001, 22, 2537 - 2541 ", "Capulary electrophoresis with on-chip four-electrode capacitively coupled conductivity detection for application in bioanalysis", a miniaturized analysis system having a channel, a liquid reservoir and a detector.

Document EP1016864A2 discloses a process for microfabrication of an integrated PCRCE device.

Thus, there is a need for a simple, inexpensive, and micromachinable detecting device with application to a variety of micro-analysis system.

### SUMMARY OF THE INVENTION

It is a primary object of the present invention to provide a simple, inexpensive and easily micromachinable micro-electric detector system useful for measuring dielectric or electrical properties of a test sample in microchannel on chip.

It is yet another object of the invention to provide a method for detecting biological material in a test sample on chip, using said micro-electric detector.

To achieve the foregoing objects, there is provided a micro-electric detector for use in a micro-analysis system, comprising: a first substrate having a first surface, comprising at least one microchannel and at least one reservoir in fluid communication with the microchannel; a second substrate having a second surface disposed on the first surface of the first substrate; and a sensing portion comprising at least one pair of first electrodes for detection, and disposed on the second surface of the second substrate along the microchannel, such that the first electrodes are positioned facing a bottom of the microchannel.

To achieve the foregoing objects, there is further provided a method for producing a micro-electric detector for use in a micro-analysis system, comprising: forming at least one microchannel and at least one reservoir in fluid communication with the microchannel, on a first surface of a first substrate; forming at least one pair of first electrodes for detection on a second surface of a second substrate; and attaching the second surface of the second substrate to the first surface of the first substrate such that the first electrodes are positioned facing a bottom of the microchannel.

To achieve the foregoing objects, there is further provided a method for monitoring a sample in a micro-analysis system, comprising: a) providing a micro-electric detector in a micro-analysis system, the micro-electric detector comprising: a first substrate having a first surface, comprising at least one microchannel and at least one reservoir in fluid communication with the microchanne; a second substrate having a second surface disposed on the first surface of the first substrate; and a sensing portion comprising at least one pair of first electrodes for detection, and disposed on the second surface of the second substrate along the microchannel, such that the first electrodes are positioned facing a bottom of the microchannel; b) supplying an electrical power to the first electrodes; c) injecting a sample into the microchannel; and d) detecting a change in a dielectric property of the sample by the sensing portion as the sample flows down the microchannel, thereby identifying a biological material in the sample.

### BRIEF DESCRIPTION OF THE DRAWINGS

The above objective and advantages of the present invention will become more apparent by describing in detail a preferred embodiment thereof with reference to the attached drawings in which:
FIG. 1 is a schematic plan view of a micro-electric detection system according to one embodiment of the invention;
FIG. 2 is an enlarged view of a microchannel and a sensing portion of a chip according to one embodiment of the invention;
FIG. 3 is an enlarged sectional view of a microchannel illustrating an operation of the sensing portion according to one embodiment of the invention;
FIG. 4 illustrates a process of manufacturing a chip employing a micro-electric detector according to one embodiment of the invention;
FIG. 5a is a graph of the dielectric constant and dielectric loss as a function of frequency, being measured in various media using a micro-electric detector of the invention.
FIG. 5b is a graph of the real impedance and imaginary impedance as a function of frequency, being measured in various media using a micro-electric detector of the invention.
FIG. 5c is a graph of the real admittance and imaginary admittance as a function of frequency, being measured in various media using a micro-electric detector of the invention.

### DETAILED DESCRIPTION OF THE INVENTION

The present invention is directed to a micro-electric detector, which can be utilized in a variety of micro-analysis systems. This invention is based on the fact that a dielectric property, such as dielectric constant, dielectric loss, impedance, and admittance, is changed where there is a charged high molecular weight compound in a sample. The micro-electric detector of the present invention includes a microchannel through which a sample flows. A biological material contained in the sample is detected by the micro-electric detector by measuring a change in a dielectric property of the sample. The micro-electric detector of this invention can be conveniently integrated in a chip, for example, a polymerase chain reaction (PCR) chip or a capillary electrophoresis (CE) chip. In a lab-on-a-chip technology, a series of processes, including sample injection, pre-treatment process, gene amplification, electrophoresis, and assay, are performed collectively in microchannels on a chip. In order to realize a reliable lab-on-a-chip, a flow of a biological material such as DNA should be monitored and controlled in operation of the chip.

When the micro-electric detector of this invention is utilized in a micro-analysis system including a lab-on-a-chip, it may be served as a device for monitoring a flow of a biological material and detecting a dielectric change therein.

Also, when the micro-electric detector of this invention is utilized in a PCR/CE chip, it may be served as a DNA detector for sensing DNA bands separated by their size in a microchannel for electrophoresis.

A micro-electric detector of the present invention comprises a first substrate having a first surface. The first surface of the first substrate includes at least one microchannel and at least one reservoir in fluid communication with the microchannel. The micro-electric detector of the present invention comprises a second substrate having a second surface disposed on the first surface of the first substrate. In Addition, The micro-electric detector of the present invention comprises a sensing portion comprising at least one pair of first electrodes for detection. The sensing portion is disposed on the second surface of the second substrate along the microchannel such that the first electrodes are placed facing a bottom of the microchannel.

The micro-electric detector of this invention may further comprises at least one pair of second electrodes for electrophoresis disposed on the second surface of the second substrate. The second electrodes are positioned to be adjacent to the ends of the microchannel, which is used as a capillary for electrophoresis.

According to the present invention, an alternating signal voltage is supplied to the pair of first electrodes of the sensing portion. Then, a dielectric property, such as dielectric constant, dielectric loss, impedance, or admittance, is measured, thereby monitoring any change in the dielectric properties of a sample. Through the monitoring, a high molecular weight material, such as DNA, in the sample is detected. In one embodiment of the present invention, a change in a dielectric constant or a dielectric loss is clearly recognizable depending on the presence/absence of DNA. In fact, the change in a sample including DNA is ten (10) times or more compared with that in a sample without DNA, which indicates that the micro-electric detector of this invention is very sensitive in detecting biological materials in a sample.

Further, when the micro-electric detector of this invention, having many advantageous features as above, is applied to a lab-on-a-chip including a PCR/CE chip, the first and the second pairs of electrodes are formed on one surface, i.e. the second surface of the second substrate, through one-step process. Therefore, manufacturing process thereof employing MEMS can be greatly simplified process.

The micro-electric detector of the invention is fabricated by micromachining process using any biocompatible materials. As used herein, the term "micromachining process" refers to techniques which are used in electronics and microsensor fabrication industries, and includes processes of etching, thin film deposition, lithographic patterning, and the like

Referring to the drawings, in which like structures are provided with like reference characters or numerals, the drawings schematically illustrate a basic structure of a micro-detector. Additional components known in the art are not included for clarity of the drawings.

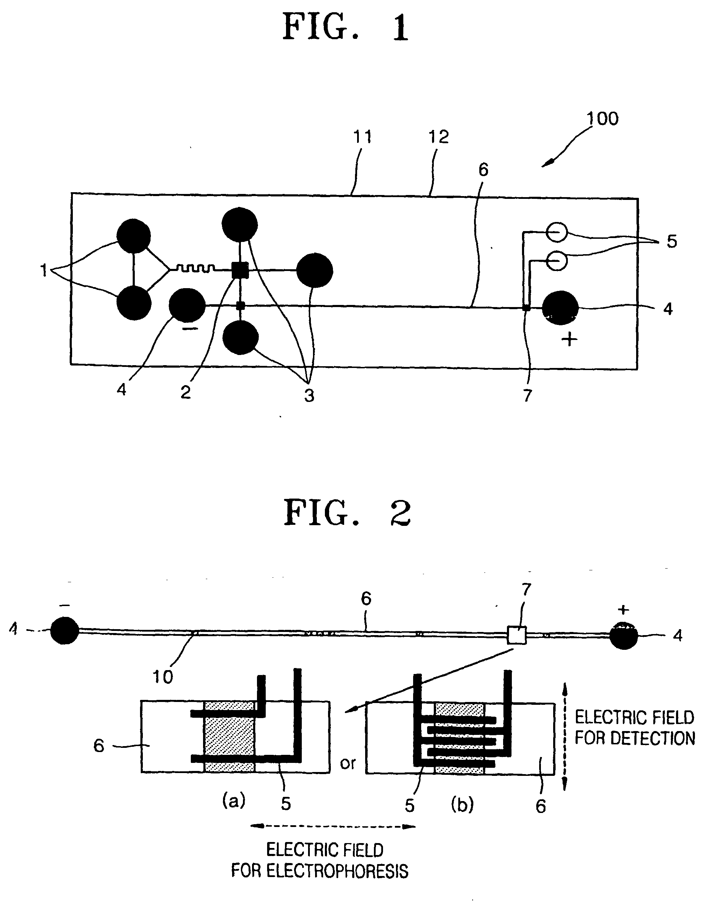

FIG. 1 is a schematic plan view of a micro-electric detection system (100) according to the invention. The micro-electric detection system (100) of FIG. 1 is a kind of a PCR/CE chip. In FIG. 1, the detection system (100) comprises first and second substrates, one of which is placed on the other. For convenience in exampling the structure of the detection system (100), a first surface (11) of the first substrate and a second surface (12) of the second substrate appear overlapped in FIG. 1.

The first and second substrates may include glass, silicon, quartz, polymethyl methacrylate (PMMA), poly(dimethylsiloxane) (PDMS), polyimide, polypropylene, polycarbonate, activated acrylamide, or composites or combinations thereof.

A microchannel (6), for performing electrophoresis, and a PCR chamber (2) as a kind of a reservoir are formed on the first surface (11) of the first substrate. While, a pair of first electrodes (5) for detection and a pair of second electrodes (4) for electrophoresis are formed on one surface of the substrates, particularly the second surface (12) of the second substrate. The system further comprises inlets and outlets (not shown) in one of the substrates, and pressurizing portion (3) for facilitating a flow of the sample from the PCR chamber (2) to the microchannel (6).

As described above, since the electrodes (5) for detection and electrodes (4) for electrophoresis are formed on one surface without having microchannel, all electrodes are simultaneously made through one photolithography step, using one pattern mask. This simplifies a manufacturing process of a chip. This effect cannot be achieved by a conventional method in which electrodes for detection are formed on sidewalls of a microchannel.

FIG. 2 is an enlarged view illustrating a structural relationship between the microchannel (6) and a sensing portion (7) in the micro-electric detection system according to the present invention.

The sensing portion (7) may comprise one pair of detector electrodes, or at least two pairs of detector electrodes arranged in an array at predetermined intervals along the microchannel (6). As described above, the microchannel is formed on the first substrate, and the electrodes for detection (5) are formed on the second substrate such that the electrodes (5) are placed opposite a bottom of the microchannel when the first and second substrates are assembled to form the micro-electric detector.

The electrodes in the sensing portion (7) may be of simple type (a), or interdigitated type (b). As used herein, the term "interdigitated type" of electrodes defines an electrode structure, in which each electrode has several arms, and the arms of one electrode alternate with the arms of the opposite electrode. According to this type of electrode, broader working area of electrode can be achieved.

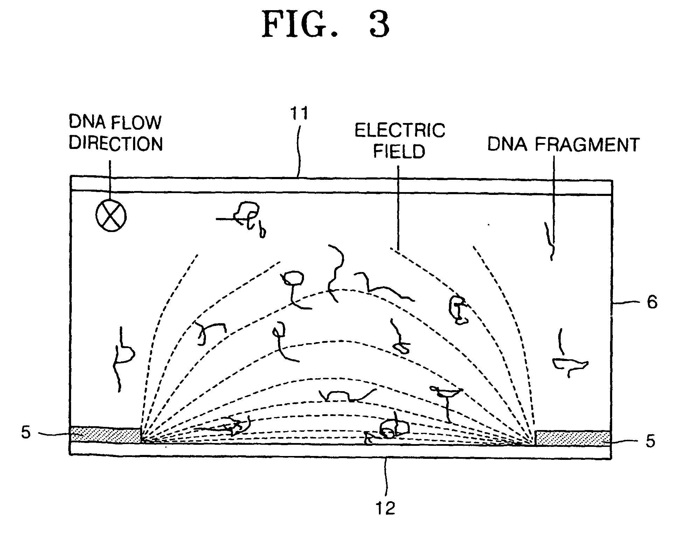

FIG. 3 is an enlarged sectional view of the microchannel illustrating an operation of the sensing portion (7) according to the invention. The pair of first electrodes (5) are formed on the second surface (12) of the second substrate.

Preferably, the pair of first electrodes (5) in sensing portion (7) are placed so that direction of electric field of the pair of first electrodes (5) may cross perpendicularly to that of electric field of the pair of second electrodes (4) for electrophoresis, since very high voltage is applied for electrophoresis in direction of microchannel. This structure can minimize any possible noises, which may be created by voltage of electrophoresis, in detection of DNA band.

Hereinafter, a method for monitoring a sample using the detection system of the present invention and operational process of the system are described.

A solution containing a biological material, such as blood cell, hair root cell, or cheek cell, and PCR buffer solution are added in a mixer, and then mixed well. The mixture is supplied into the PCR chamber (2). In the PCR chamber (2), desired DNA fragments are amplified through 30 or more cycles of enzymatic reactions. The PCR product moves into the microchannel (6) for electrophoresis, which is facilitated by the pressurizing portion (3). The PCR product migrates along the microchannel (6) by applying a very high electric field via a pair of second electrodes (4) for electrophoresis. In the migration, DNAs with like size form a DNA band of high density of DNA. Consequently, DNAs in the PCR product form one or more DNA bands depending on the molecular weight, because mobility of DNA is dependent on its length. The DNA bands may be monitored by measuring a dielectric property by the pair of first electrodes (5) in the sensing portion (7).

In order to measure a dielectric property, an electrical power is supplied to the first electrodes (5). Preferably, an alternating signal voltage with a frequency in the range of 0.1 Hz - 100MHz is applied to the first electrodes (5). Vᵣₘₛ is maintained at 5mV - 2V, and bias voltage is adjusted to 0V - 10V. In case of detecting a DNA movement, the dielectric measurement is performed with scanning from a low frequency to high a frequency. While, in case of detecting a DNA band in electrophoresis, the dielectric measurement is performed at a fixed frequency, which enables distinction between the dielectric properties of buffer (control solution) and those of a mixture of DNA and buffer (sample solution)

When the power is supplied to the pair of first electrodes (5) as above, an electric field is created as illustrated in FIG. 3. If any charged particle passes through this electric field, the particle responds to the electric field, and shows a distinct behavior. Particularly, where any temporary dipole or permanent dipole, or charged particle exists in a dielectric medium flowing between opposite electrodes, a capacitance tends to increase with applying an electric field of an alternating signal voltage. This dielectric properties vary depending on the medium between the opposite electrodes.

Actually, important factors in determining dielectric properties of a material include a dielectric constant and a response time. Dielectric constant is quite relative to a quantity of dipole moment or electric charge. Response time is affected by a mass or size of a particle, and atmospheric conditions.

In addition, impedance means a hindrance to the flow of alternating current, which is dependent on ion concentration, and existence and length of DNA in a sample.

According to a method for detecting a biological material, for example, DNA, in a sample, a dielectric constant, impedance, admittance, or other electric properties of the sample is measured, and the dielectric properties of the sample is compared with a reference, thereby determining the existence or length of DNA.

In case of DNA electrophoresis, counter ions, to compensate for negative charge of DNA, are concentrated around a DNA band formed. Therefore, an electric signal difference between in the sample including DNA, and a reference is apparent.

As described above, a variety of samples can be monitored by the detector of the invention through measuring dielectric constant, dielectric loss, impedance of admittance variations in a microchannel, such as particulate containing fluids and biological materials including living cells and subcellular structures.

The present invention further provides a method for producing a micro-electric detector for use in a micro-analysis system. The method for producing a micro-electric detector comprises forming at least one microchannel and at least one reservoir in fluid communication with the microchannel, on a first surface of a first substrate. The method also comprises forming at least one pair of first electrodes for detection on a second surface along the microchannel. The method further comprises attaching the second surface of the second substrate to the first surface of the first substrate.

The method may further comprise forming at least one pair of second electrodes for electrophoresis on the second surface at both ends of the microchannel.

The attaching the second surface of the second substrate to the first surface of the first substrate is performed by polymer film bonding, anodic bonding, or thermal bonding.

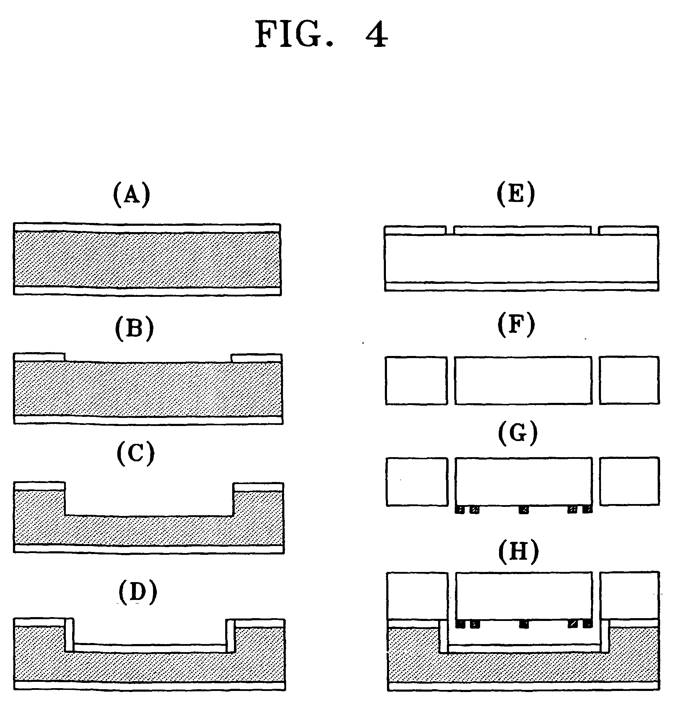

FIG. 4 illustrates a process of manufacturing a chip employing a micro-electric detector according to one embodiment of the invention;

The microchannel (6) and associated electrodes (4,5) of detection system (100) are fabricated using conventional micromachining techniques. The microchannels can be formed by various processes such as etching, photolithographic, or printing processes. The electrodes can be formed by various processes such as physical vapor deposition or electrodeposition of a conductive material, followed by patterning.

As illustrated in FIG. 4, the electrodes (5) for detection and electrodes (4) for electrophoresis are simultaneously formed on one surface through one photolithography step, using one pattern mask. Therefore, single step-process is required for forming electrodes, independently of the number of electrodes to be formed. Accordingly, multi-detector structure of a chip can be achieved through a simple process in a short time at low cost.

Further, a measuring mechanism employed in the present invention is very simple, and does not require lots of peripheral devices for the detector, which lowers the cost for constructing a micro-analysis system employing the detector of the present invention.

Besides, the micro-electric detector of the present invention can be implemented on an opaque chip unlike the conventional optical method. Also, the detecting method of the present invention provides response time of a sample and a length of DNA present in the sample unlike the other conventional measurement.

A PCR/CE chip employing the detecting system of the present invention provides an optimal detection for DNA band, with a simple manufacturing process and a low cost.

Further, the electrode structure employed in the detector of the present invention can be also utilized to be a switch and/or valve, for controlling a flow of DNA.

The present invention will be more fully described with reference to the following examples. However, the present invention is not restricted to the examples below.

### Example 1

### Production of a PCR/CE chip employing a micro-electric detector

A first oxide film was formed on a first surface of a first silicon substrate, by wet oxidation process ((A) in FIG. 4). PCR chambers and microchannels for electrophoresis were formed on the first surface by photolithography ((B) in FIG. 4) and reactive ion etching ((C) in FIG. 4). Next, the remaining first oxide film was removed using a diluted solution of fluoric acid, and then a second oxide film was formed ((D) in FIG. 4).

A photoresist film having Inlet and outlet pattern was placed on a second surface of a second glass substrate by photolithography ((E) in FIG. 4), and then inlet and outlet were formed using sandblaster ((F) in FIG. 4). The residual photoresist film was melted with acetone. Then, a pattern mask of electrodes for detection and electrophoresis was formed on the second substrate by photolithography. A Pt/Ti or Au/Cr film was deposited sequentially on the second glass substrate by sputtering. Then, a lift-off process was performed using acetone, thereby forming electrode patterns ((G) in FIG. 4).

The first surface of the first substrate comprising PCR chambers and microchannels was joined to the second surface of the second substrate having electrodes for detection and electrophoresis by anodic bonding ((H) in FIG. 4), so that the electrodes for detection are positioned facing a bottom of the microchannels, and the electrodes for electrophoresis are positioned around the ends of the maicrochannels. The joined substrates were diced, to obtain a final chip.

### Example 2

### Detection of DNA

A PCR reactant was introduced into the PCR chamber, of the chip produced in Example 1, through the inlet. In the PCR chamber, PCR was performed through cycling of temperatures. Resultant PCR product was moved into the microchannel for electrophoresis, and then electrophoresis was performed by applying electricity to the electrodes for electrophoresis disposed at the ends of the microchannel. At the same time, an alternating signal voltage was applied to the electrodes for detection, with measuring dielectric constant, dielectric loss, impedance, and admittance of the PCR product at the electrode tips. Based on any changes in the dielectric properties, a DNA band was detected.

### Dielectric properties as a function of frequency

For each sample of a distilled water, buffer (NaH₂PO₄ solution), and buffer solution of DNA, dielectric constant, dielectric loss, impedance, and admittance are measured using the detector as described above.

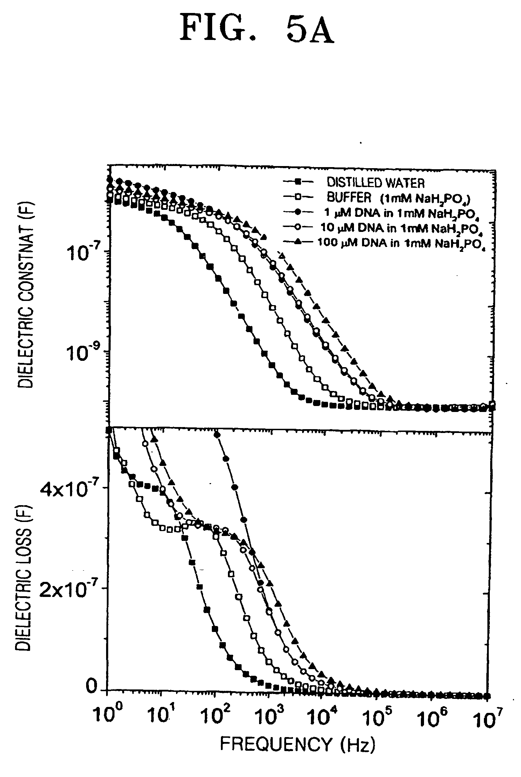

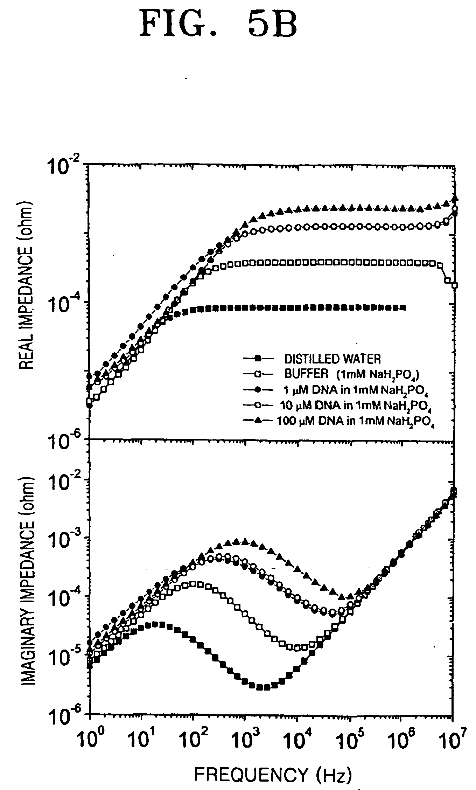

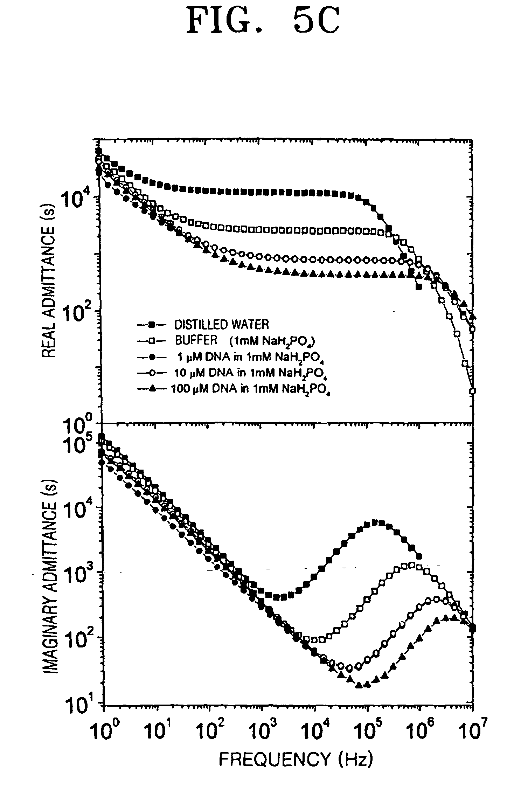

FIGs. 5a, 5b and 5c are graphs showing the dielectric properties for each sample with a variation in frequency.

FIG. 5a shows data for the dielectric constant and dielectric loss, measured at frequency of 0.1 Hz - 10⁸ Hz. In this test, there occurred a wider difference in dielectric constant than in dielectric loss, between the sample including DNA and controls(references) without DNA.

The dielectric constant of buffer differs a little from that of buffer solution of DNA at low or high frequency. While, at frequency of 10 Hz - 100 kHz, the dielectric constant of buffer solution of DNA is 10 times or more larger than that of buffer. Dielectric constant difference between 1µM buffer solution of DNA and buffer is about 10 fold, despite the low DNA concentration. Based on the fact that DNA concentration in a PCR product is generally 100 µM or more, biological materials in a sample can be detected very easily in a PCR/CE chip using the micro-electric detector.

Regarding dielectric loss, that of buffer was not very different from that of buffer solution of DNA, compared to the case of dielectric constant, because of short DNA length of 15 mer. If DNA length is longer than 15 mer, a frequency range showing a large dielectric loss would shift, thereby giving a wider difference between dielectric loss of buffer and that of buffer solution of DNA. Since an average length of DNA in a general PCR product may be about 100 bp - 1 kbp, it is considered that DNA in a PCR/CE chip can be detected by measuring a dielectric loss change.

FIG. 5b shows impedance data, measured at frequency of 0.1 Hz - 10⁸ Hz. In this graph, real impedance becomes stable in the frequency range of about 10 Hz - 100 kHz. Real impedance of 1 µM buffer solution of DNA is about 3 - 4 times larger than that of buffer. This indicates that selectivity of real impedance measurement is not better than that of dielectric constant measurement. However, imaginary impedance can be used as a parameter in detecting biomolecules in a sample in the frequency range of about 50 kHz - 1 MHz. It is seen that Imaginary impedance difference between 1 µM buffer solution of DNA and buffer is about 10 fold or more.

FIG. 5c shows admittance data, measured at frequency of 0.1 Hz - 10⁸ Hz. In this graph, real admittance becomes stable in the frequency of about 100 Hz and over. Real admittance of 1 µM buffer solution of DNA is about 4 times larger than that of buffer. Regarding imaginary admittance, it enables a sensitive detection in the frequency range of about 100 Hz - 100 kHz. Imaginary admittance difference between 1 µM buffer solution of DNA and buffer is up to about 10 fold.

As can be seen from the result of above test, each of dielectric properties is very dependent on DNA concentration, DNA length, buffer concentration and the like. In addition, it is also dependent on a material of the electrodes, ambient temperature, and other conditions. Therefore, a specific frequency range and dielectric property should be selected carefully based on a structure of a chip, type of genes of PCR product, selected buffer and so on.

The present invention may be embodied in other specific forms without departing from its spirit or essential characteristics. The above embodiments are to be considered in all respects only as illustrative and not restrictive. The scope of the invention is, therefore, defined by the appended claims rather than by the foregoing description.

## Claims

1. A micro-electric detector (100) for use in a micro-analysis system, comprising:
a first substrate having a first surface (11), comprising at least one microchannel and at least one reservoir in fluid communication with the microchannel;
a second substrate having a second surface (12) disposed on the first surface (11) of the first substrate; and
a sensing portion (7) comprising at least one pair of first electrodes (5) for detection, and disposed on the second surface of the second substrate along the microchannel (6), such that the first electrodes are positioned facing a bottom of the microchannel (6)
**characterized by**
further comprising at least one pair of a second electrodes (4) for electrophoresis disposed on the second surface (12) of the second substrate adjacent to opposite ends of the microchannel (6), wherein the microchannel (6) is used as a capillary channel for electrophoresis.

2. The detector of claim 1, wherein the reservoir comprises at least one PCR chamber in which polymerase chain reaction is performed.

3. The detector of any of claims 1 or 2, wherein at least one of the first and second substrates comprises an inlet and an outlet.

4. The detector of any of claims 1 to 3, wherein the first electrodes (5) is an interdigitated type of electrode.

5. The detector of any of claims 1 to 4, wherein the sensing portion (7) comprises at least two parts of first electrodes (5) arranged in an array at predetermined intervals along the microchannel (6).

6. The detector of any of claims 1 to 5, wherein the first and second substrates include glass, silicon, quartz, polymethyl methacrylate (PMMA), poly (dimethylsiloxane) (PDMS), polyimide, polypropylene, polycarbonate, activated acrylamide, or composites or combinations thereof.

7. A method for producing a micro-electric detector (100) for use in a micro-analysis system, comprising:
forming at least one microchannel (6) and at least one reservoir in fluid communication with the microchannel (6), on a first surface (11) of a first substrate;
forming at least one pair of first electrodes (5) for detection on a second surface (12) of a second substrate; and
attaching the second surface (12) of the second substrate to the first surface (11) of the first substrate such that the first electrodes (5) are positioned facing a bottom of the microchannel (6)
**characterized by**
the method, further comprising forming at least one pair of second electrodes (4) for electrophoresis on the second surface (12) at opposite ends of the microchannel (6).

8. The method of claim 7, wherein the attaching of the second surface (12) of the second substrate to the first surface (11) of the first substrate is performed by polymer film bonding, anodic bonding, or thermal bonding.

9. A method for monitoring a sample in a micro-analysis system, comprising:
a) providing a micro-electric detector in a micro-analysis system, the micro-electric detector comprising:
a first substrate having a first surface (11), comprising at least one microchannel (6) and at least one reservoir in fluid communication with the microchannel (6);
a second substrate having a second surface (12) disposed on the first surface (11) of the first substrate; and
a sensing portion comprising at least one pair of first electrodes (5) for detection, and disposed on the second surface (12) of the second substrate along the microchannel (6), such that the first electrodes (5) are positioned facing a bottom of the microchannel (6);
b) supplying an electrical power to the first electrodes (5);
c) injecting a sample into the microchannel (6); and
d) detecting a change in a dielectric property of the sample by the sensing portion as the sample flows down the microchannel (6), thereby identifying a biological material in the sample,
wherein the micro-electric detector (100) further comprises electrodes (4) for electrophoresis disposed on the second surface (12) of the second substrate adjacent to opposite ends of the microchannel (6), and the injected sample of step c) migrates differentially through the microchannel (6) with forming a DNA band by electrophoresis.

10. The method of claim 9, wherein the dielectric property includes dielectric constant, dielectric loss, impedance or admittance.

11. The method of claim 9 or 10, wherein the biological material includes at least one of nucleotide, protein, oligopeptide, and biological cell.

12. The method of any of claims 9 to 11, further comprising subjecting a sample to PCR before the step b), wherein the reservoir of the micro-electric detector comprise at least one PCR chamber, and the sample comprises a PCR product from the polymerase chain reaction in the PCR chamber.

13. The method of any of claims 9 to 12, wherein detecting the change in the dielectric property in step d) comprises measuring a dielectric property through scanning with fixing or varying frequency in the range of 1 Hz - 100MHz under conditions of Vᵣₘₛ of 5mV - 2V and bias voltage of 0V - 10V.

## Patentansprüche

1. Mikroelektronischer Detektor (100) zur Verwendung in einem Mikroanalyse-System, der umfasst:
ein erstes Substrat mit einer ersten Fläche (11), das zumindest einen Mikrokanal und zumindest einen Vorratsbehälter umfasst, der in Fluidverbindung mit dem Mikrokanal steht;
ein zweites Substrat mit einer zweiten Fläche (12), das auf der ersten Fläche (11) des ersten Substrats aufgebracht ist; und
einen Fühlerabschnitt (7), der zumindest ein Paar von ersten Elektroden (5) zur Detektion umfasst und der auf der zweiten Fläche des zweiten Substrats so entlang des Mikrokanals (16) angebracht ist, dass die ersten Elektroden so positioniert sind, dass sie dem Boden des Mikrokanals (6) gegenüberliegen,
**dadurch gekennzeichnet, dass**
er zumindest ein Paar von zweiten Elektroden (4) zur Elektrophorese umfasst, die auf der zweiten Fläche (12) des zweiten Substrats angrenzend an gegenüberliegende Enden des Mikrokanals (6) aufgebracht sind, wobei der Mikrokanal (6) als ein Kapillarkanal zur Elektrophorese verwendet wird.

2. Detektor nach Anspruch 1, wobei der Vorratsbehälter zumindest eine PCR-Kammer umfasst, in welcher eine Polymerase-Kettenreaktion durchgeführt wird.

3. Detektor nach irgendeinem Anspruch 1 oder 2, wobei zumindest eines von dem ersten oder zweiten Substrat einen Einlass und einen Auslass umfasst.

4. Detektor nach irgendeinem der Ansprüche 1 bis 3, wobei die ersten Elektroden (5) vom interdigitierten Elektrodentyp sind.

5. Detektor nach irgendeinem der Ansprüche 1 bis 4, wobei der Fühlerabschnitt (7) zumindest zwei Abschnitte an ersten Elektroden (5) umfasst, die in einer Anordnung mit vorgegebenen Abständen entlang des Mikrokanals (6) angebracht sind.

6. Detektor nach irgendeinem der Ansprüche 1 bis 5, wobei das erste und zweite Substrat Glas, Silizium, Quarz, Polymethylmethacrylat (PMMA), Polydimethylsiloxan (PDMS), Polyimid, Polypropylen, Polykarbonat, aktiviertes Acrylamid oder Verbunde oder Kombinationen davon einschließen.

7. Verfahren zur Herstellung eines mikroelektronischen Detektors (100) zur Verwendung in einem Mikroanalyse-System, das umfasst:
Ausbildung von zumindest einem Mikrokanal (6) und zumindest einem Vorratsbehälter, der in Fluidverbindung mit dem Mikrokanal (6) steht auf einer ersten Fläche (11) eines ersten Substrats;
Ausbildung von zumindest einem Paar von ersten Elektroden (5) zur Detektion auf einer zweiten Fläche (12) auf einem zweiten Substrat; und
Anbringen der zweiten Fläche (12) des zweiten Substrats auf die erste Fläche (11) des ersten Substrats so, dass die ersten Elektroden (5) so positioniert sind, dass sie einem Boden des Mikrokanals (6) gegenüberliegen,
**dadurch gekennzeichnet, dass**
das Verfahren ferner die Ausbildung von zumindest einem Paar von zweiten Elektroden (4) umfasst zur Elektrophorese auf der zweiten Fläche (12) an gegenüberliegenden Enden des Mikrokanals (6).

8. Verfahren nach Anspruch 7, wobei das Anbringen der zweiten Fläche (12) des zweiten Substrats auf die erste Fläche (11) der ersten Substrats ausgeführt wird durch Polymerfilm-Bonden, anodisches Bonden oder thermisches Bonden.

9. Verfahren zur Überwachung einer Probe in einem Mikroanalyse-System, das umfasst:
a) Lieferung eines mikroelektronischen Detektors in einem Mikroanalyse-System, wobei der mikroelektronische Detektor umfasst:
ein erstes Substrat mit einer ersten Fläche (11), die zumindest einen Mikrokanal (6) und zumindest einen Vorratsbehälter umfasst, der in Fluidverbindung mit dem Mikrokanal (6) steht;
ein zweites Substrat mit einer zweiten Fläche (12), das auf der ersten Fläche (11) des ersten Substrats aufgebracht ist; und
einen Fühlerabschnitt, der zumindest ein Paar von ersten Elektroden (5) zur Detektion umfasst und der auf der zweiten Fläche (12) des zweiten Substrats so entlang des Mikrokanals (16) angebracht ist, dass die ersten Elektroden (5) so positioniert sind, dass sie einem Boden des Mikrokanals (6) gegenüberliegen;
b) Lieferung eines elektrischen Stroms an die ersten Elektroden (5);
c) Injektion einer Probe in den Mikrokanal (6); und
d) Detektion einer Veränderung bezüglich einer dielektrischen Eigenschaft der Probe durch den Fühlerabschnitt während die Probe durch den Mikrokanal (6) fließt, wodurch ein biologisches Material in der Probe identifiziert wird,
wobei der mikroelektronische Detektor (100) ferner Elektroden (4) zur Elektrophorese umfasst, die auf der zweiten Fläche (12) des zweiten Substrats aufgebracht sind, angrenzend an gegenüberliegenden Enden des Mikrokanals (6) und die injizierte Probe aus Schritt c) differentiell durch den Mikrokanal (6) unter Ausbildung einer DNA-Bande durch Elektrophorese wandert.

10. Verfahren nach Anspruch 9, wobei die dielektrische Eigenschaft die dielektrische Konstante, den dielektrischen Verlust, die Impedanz oder Admittanz einschließt.

11. Verfahren nach Anspruch 9 oder 10, wobei das biologische Material zumindest eines von den Materialien Nukleotid, Protein, Oligopeptid und biologische Zelle einschließt.

12. Verfahren nach irgendeinem der Ansprüche 9 bis 11, das ferner umfasst, dass die Probe vor Schritt b) einer PCR unterzogen wird, wobei der Vorratsbehälter des mikroelektronischen Detektors zumindest eine PCR-Kammer umfasst und die Probe zumindest ein PCR-Produkt aus der Polymerase-Kettenreaktion in der PCR-Kammer umfasst.

13. Verfahren nach irgendeinem der Ansprüche 9 bis 12, wobei die Detektion der Veränderung bezüglich der dielektrischen Eigenschaft in Schritt d) das Messen einer dielektrischen Eigenschaft umfasst durch Abtasten mit Festlegung oder Variation der Frequenz in dem Bereich von 1 Hz - 100MHz unter den Bedingungen von Vᵣₘₛ bei 5mV - 2V und einer Vorspannung von 0V - 10V.

## Revendications

1. Détecteur micro-électrique (100) destiné à être utilisé dans un système de micro-analyse, comportant :
un premier substrat ayant une première surface (11), comportant au moins un micro-canal et au moins un réservoir en communication fluidique avec le micro-canal,
un second substrat ayant une seconde surface (12) disposée sur la première surface (11) du premier substrat, et
une partie de détection (7) comportant au moins une paire de premières électrodes (5) pour une détection, et disposée sur la seconde surface du second substrat le long du micro-canal (6), de sorte que les premières électrodes sont positionnées en faisant face au fond du micro-canal (6),
**caractérisé en ce qu'**il
comporte de plus au moins une paire de secondes électrodes (4) pour une électrophorèse disposée sur la seconde surface (12) du second substrat à proximité adjacente d'extrémités opposées du micro-canal (6), le micro-canal (6) étant utilisé en tant que canal capillaire pour une électrophorèse.

2. Détecteur selon la revendication 1, dans lequel le réservoir comporte au moins une chambre PCR dans laquelle une amplification en chaîne par polymérase est effectuée.

3. Détecteur selon la revendication 1 ou 2, dans lequel au moins un des premier et second substrats comporte une entrée et une sortie.

4. Détecteur selon l'une quelconque des revendications 1 à 3, dans lequel les premières électrodes (5) sont un type d'électrode inter-digitée.

5. Détecteur selon l'une quelconque des revendications 1 à 4, dans lequel la partie de détection (7) comporte au moins deux parties de premières électrodes (5) agencées en une rangée à des intervalles prédéterminés le long du micro-canal (6).

6. Détecteur selon l'une quelconque des revendications 1 à 5, dans lequel les premier et second substrats incluent du verre, silicium, quartz, polyméthacrylate de méthyle (PMMA), poly(diméthylsiloxane) (PDMS), polyimide, polypropylène, polycarbonate, acrylamide activé, ou des composites ou combinaisons de ceux-ci.

7. Procédé pour produire un détecteur micro-électrique (100) destiné à être utilisé dans un système de micro-analyse, comportant les étapes consistant à :
former au moins un micro-canal (6) et au moins un réservoir en communication fluidique avec le micro-canal (6), sur une première surface (11) d'un premier substrat,
former au moins une paire de premières électrodes (5) pour une détection sur une seconde surface (12) d'un second substrat, et
attacher la seconde surface (12) du second substrat à la première surface (11) du premier substrat de sorte que les premières électrodes (5) sont positionnées en faisant face au fond du micro-canal (6),
**caractérisé en ce que**
le procédé comporte de plus la formation d'au moins une paire de secondes électrodes (4) pour une électrophorèse sur la seconde surface (12) au niveau d'extrémités opposées du micro-canal (6).

8. Procédé selon la revendication 7, dans lequel la fixation de la seconde surface (12) du second substrat à la première surface (11) du premier substrat est effectuée par une liaison de film polymère, une liaison anodique, ou une liaison thermique.

9. Procédé pour surveiller un échantillon dans un système de micro-analyse, comportant les étapes consistant à :
a) agencer un détecteur micro-électrique dans un système de micro-analyse, le détecteur micro-électrique comportant :
un premier substrat ayant une première surface (11) comportant au moins un micro-canal (6) et au moins un réservoir en communication fluidique avec le micro-canal (6),
un second substrat ayant une seconde surface (12) disposée sur la première surface (11) du premier substrat, et
une partie de détection comportant au moins une paire de premières électrodes (5) pour une détection, et disposée sur la seconde surface (12) du second substrat le long du micro-canal (6), de sorte que les premières électrodes (5) sont positionnées en faisant face au fond du micro-canal (6),
b) alimenter en énergie électrique les premières électrodes (5),
c) injecter un échantillon dans le micro-canal (6), et
d) détecter un changement de propriété diélectrique de l'échantillon par la partie de détection lorsque l'échantillon s'écoule vers le bas du micro-canal (6), de manière à identifier un matériel biologique dans l'échantillon,
dans lequel le détecteur micro-électrique (100) comporte de plus des électrodes (4) pour une électrophorèse disposées sur la seconde surface (12) du second substrat à proximité adjacente d'extrémités opposées du micro-canal (6), et l'échantillon injecté de l'étape c) migre de manière différentielle à travers le micro-canal (6) avec formation d'une bande d'ADN par électrophorèse.

10. Procédé selon la revendication 9, dans lequel la propriété diélectrique inclut une constante diélectrique, une perte diélectrique, une impédance ou une admittance.

11. Procédé selon la revendication 9 ou 10, dans lequel le matériel biologique inclut au moins l'un parmi un nucléotide, une protéine, un oligopeptide, et une cellule biologique.

12. Procédé selon l'une quelconque des revendications 9 à 11, comportant de plus l'étape consistant à soumettre un échantillon à une PCR avant l'étape b), dans lequel le réservoir du détecteur micro-électrique comporte au moins une chambre PCR, et l'échantillon comporte un produit PCR provenant de l'amplification en chaîne par polymérase dans la chambre PCR.

13. Procédé selon l'une quelconque des revendications 9 à 12, dans lequel la détection du changement de la propriété diélectrique à l'étape d) comporte la mesure d'une propriété diélectrique par balayage avec une fréquence fixe ou variable dans la plage de 1 Hz - 100 MHz sous des conditions de Vₘₛ de 5mV - 2V et une tension de polarisation de OV - 10V.
